**Europäisches Patentamt**

**European Patent Office**

**Office européen des brevets**

(11) Numéro de publication : **0 578 688 B1**

(12) # FASCICULE DE BREVET EUROPEEN

(45) Date de publication du fascicule du brevet :
**21.06.95 Bulletin 95/25**

(51) Int. Cl.$^6$ : **G01R 33/12, H01M 10/54, G01N 27/72, B07C 5/00**

(21) Numéro de dépôt : **92907573.7**

(22) Date de dépôt : **02.04.92**

(86) Numéro de dépôt international :
**PCT/EP92/00742**

(87) Numéro de publication internationale :
**WO 92/17791 15.10.92 Gazette 92/26**

(54) **PROCEDE ET INSTALLATION DE TRI DES PILES ET ACCUMULATEURS USAGES.**

(30) Priorité : **04.04.91 EP 91810246**

(43) Date de publication de la demande :
**19.01.94 Bulletin 94/03**

(45) Mention de la délivrance du brevet :
**21.06.95 Bulletin 95/25**

(84) Etats contractants désignés :
**BE DE ES FR IT NL**

(56) Documents cités :
**WO-A-91/15036**
**NICKEL-CADMIUM BATTERY UPDATE 90,**
**Septembre 90, BRUSSELS, pages 66-71,**
**W.H.J. BRUIS: "Sorting of Mixed Batteries by**
**Eddy Current and X-Ray Image Analysis**
**Method"**

(56) Documents cités :
**20 janvier 1990, UNIVERSITY OF LUND, SWE-**
**DEN, pages 45-76, THOMA LINDHQVIST ET**
**AL.: "Collection and Sorting of Used Batte-**
**ries"**

(73) Titulaire : **TITALYSE S.A.**
**7 rue Marcinhés**
**CH-1217 Meyrin (CH)**

(72) Inventeur : **NGUYEN, Trong, Thinh**
**Route du Grand-Lancy 165**
**CH-1213 Onex (CH)**
Inventeur : **WIAUX, Jean-Pol**
**Route d'Annecy 239**
**CH-1257 Croix-de-Rozon (CH)**

(74) Mandataire : **Cronin, Brian Harold John**
**Moinas, Kiehl & Cronin**
**42 rue Plantamour**
**CH-1201 Genève (CH)**

EP 0 578 688 B1

EP 0 578 688 B1

## Description

La présente invention se rapporte à un procédé et à une installation de tri de piles et accumulateurs usagés, ainsi qu'à un dispositif de mesure des propriétés ferromagnétiques de ceux-ci.

Depuis l'apparition des premières piles Zn-carbone sur le marché au début du siècle, la consommation de ces sources d'énergie portables ne cesse d'augmenter, que ce soit dans les activités professionnelles, ou dans la vie quotidienne. Cette augmentation de la consommation de piles ou accumulateurs a encore accéléré durant ces vingt dernières années avec l'accroissement de l'utilisation des appareils électriques ou électroniques portables.

Parallèlement à cette augmentation de consommation, d'autres types de piles ou accumulateurs plus performants font leur apparition sur le marché: les piles alcalines au $Zn-MnO_2$ au milieu des années 70, les piles au Lithium et à l'Argent au début des années 80, et les accumulateurs rechargeables au Ni-Cd durant ces dernières années.

Actuellement, la consommation de piles et accumulateurs en Europe occidentale est estimée à 100'000 tonnes par année, réparties en une dizaine de types de nature chimique différente.

Malgré les efforts considérables de la part des producteurs pour diminuer la charge des éléments très toxiques tels que le Cadmium et le Mercure, les piles et accumulateurs usagés, dûs à leur contenu de métaux lourds, sont considérés comme un déchet toxique et doivent être traités spécifiquement.

La question du problème du traitement de ces piles et accumulateurs usagés était le sujet de plusieurs débats depuis dix ans. Cette question devient de plus en plus prioritaire pour les pays occidentaux industrialisés, car la masse des piles et accumulateurs usagés rejetés dans les ordures urbaines augmente sans cesse. On comprend aisément les conséquences désastreuses sur l'environnement dues à l'émission des métaux lourds provenant de l'incinération de ces ordures urbaines.

Pour faire face à cette situation, les pouvoirs publics ont organisé depuis quelques années des campagnes de collecte des piles et accumulateurs usagés pour leurs traitements ultérieurs. Plusieurs tentatives et essais ont démontré qu'une collecte sélective de ces piles et accumulateurs usagés du grand public est techniquement impossible. Ces piles et accumulateurs sont donc collectés sous forme de mélanges, constitués par environ 200 à 250 types selon leur dimension, leur forme et leur nature chimique. Ces mélanges de piles et accumulateurs usagés sont actuellement stockés ou mis en décharge contrôlée, faute d'un procédé de traitement techniquement et économiquement fiable.

Plusieurs techniques de traitement-recyclage des piles et accumulateurs ont été développés, et sont actuellement opérationnelles au niveau industriel. Ces procédés sont généralement développés pour traiter un seul type de piles ou d'accumulateurs provenant des rebuts de production ou d'une collecte sélective.

Ces procédés de traitement et de recyclage sont des technologies complexes. Pour un type de piles ou d'accumulateurs donné, le procédé doit pouvoir traiter plusieurs composés chimiques métalliques ou non-métalliques, dont la séparation demande un contrôle sévère des conditions opérationnelles. En général, le seuil admissible d'éléments étrangers de ces procédés, par exemple un autre type de piles ou d'accumulateurs dans une charge donnée, ne peut pas dépasser 1% du poids.

Il est donc aisé de comprendre qu'il n'existe à ce jour aucune usine de traitement-recyclage des mélanges de piles et accumulateurs usagés collectés, faute d'un tri préalable les séparant selon leur nature chimique pour un traitement sélectif subséquent.

Devant cette réalité, le développement d'un procédé et d'équipements appropriés pour trier les mélanges de piles ou accumulateurs collectés devient une nécessité vitale pour les procédés de traitement subséquent.

Plusieurs possibilités ont été envisagées pour le tri des piles ou accumulateurs usagés selon leur nature chimique, à partir des mélanges collectés auprès du grand public.

En tenant compte de leur taille, de leur forme et de leur nature chimique, environ 200 à 250 types de piles ou accumulateurs sont répertoriés sur le marché. Une telle diversité des lots à trier nécessite l'établissement d'un schéma de tri logique afin d'éviter un travail trop fastidieux et inutile. En général, la technique de tri des piles ou accumulateurs usagés comprend au moins deux étapes successives :

- Première étape : un tri mécanique préalable du lot afin de séparer les piles ou accumulateurs selon leur forme et/ou leurs dimensions.
- Deuxième étape : pour une forme et/ou des dimensions données, la nature chimique des piles ou accumulateurs est déterminée par la mesure d'un ou plusieurs paramètres caractéristiques de la pièce concernée.

Par exemple, la nature chimique d'une pile ou d'un accumulateur peut être déterminée par la mesure de sa masse spécifique. En effet, une pile saline au Zinc-Carbone possède une masse spécifique d'environ 1,9 $g/cm^3$, une pile alcaline au $Zn-MnO_2$ de 3,0 $g/cm^3$, et un accumulateur au Ni-Cd de 3,6 $g/cm^3$. Cette méthode comporte une étape de tri mécanique pour séparer chaque classe de piles ou accumulateurs selon leurs di-

2

mensions, suivie d'une détermination du poids pour chaque pièce. Une éventuelle reconnaissance de la forme et des dimensions de la pile ou accumulateur par des moyens optiques, mécaniques ou électro-mécanique permettrait de compléter ou de supprimer l'étape de tri mécanique. Selon le principe de tri se basant sur la masse spécifique, une flottation sélective dans un ou plusieurs milieux appropriés a aussi été proposée. Toutefois, une application industrielle de tels procédés serait improbable à cause du manque de fiabilité. En effet, si la différence de la masse spécifique des différents types de piles et accumulateurs est bien marquée en théorie, en pratique, cette reconnaissance est beaucoup plus complexe et dans certains cas, les valeurs sont complètement inversées. Lorsqu'une pile ou un accumulateur usagé est stocké dans un endroit non-protégé durant une longue période, sa masse spécifique peut varier dans une large limite à cause des problèmes d'absorption de l'humidité, de fuites de l'électrolyte ou de corrosion. De ce fait, la mesure de la masse spécifique d'une pile ou d'un accumulateur usagé n'est pas un moyen fiable pour déterminer sa nature chimique.

Les mesures des propriétés thermiques, acoustiques ou électriques sont aussi envisagées pour le tri des piles et accumulateurs usagés. Par exemple l'analyse de la vitesse de propagation des ultrasons à travers le corps de la pièce à analyser, ou la mesure du pouvoir de dissipation thermique de la pièce après une courte période de chauffage, ou encore la mesure de la résistance électrique résiduelle sont des indications directement liées à la composition ou/et la structure interne de la pile ou l'accumulateur usagé. Cependant comme dans le cas précédent, et pour les mêmes raisons dues à l'altération de l'état des piles ou accumulateurs après usage ou pendant leur stockage, ces méthodes ne peuvent pas garantir une fiabilité de tri suffisante.

L'analyse de la composition interne de la pile ou de l'accumulateur s'impose donc comme méthode fiable pour la détermination de leur nature chimique. Toutefois, pour des raisons techniques, économiques et de sécurité, l'analyse de la composition interne doit s'effectuer avec des piles ou accumulateurs non ouverts. La méthode d'analyse utilisée devrait donc permettre de supprimer l'influence des couches extérieures de l'enveloppe de la pile ou de l'accumulateur.

L'analyse directe de la composition interne des piles et accumulateurs par les méthodes basées sur rayons-X, par fluorescence ou par image d'absorption a déjà été proposée (W.H.J. BRUIS : *Sorting of mixed batteries by eddy current and X-ray image analysis methods - Nickel- Cadmium battery update 90* - Brussels - September 1990). Cependant ces techniques requièrent des équipements sophistiqués, délicats, une main d'oeuvre qualifiée et surtout un temps d'analyse très long, par exemple une durée de 10 secondes par pièce est nécessaire pour accomplir une analyse par fluorescence X. Ces exigences ne sont pas compatibles avec les conditions opérationnelles et de rentabilité d'un procédé de traitement des déchets tels que les piles et accumulateurs usagés.

L'analyse indirecte de la composition interne est également possible par la mesure des propriétés physiques ou physico-électriques des métaux constituant la masse active des piles ou accumulateurs. La mesure des propriétés ferromagnétiques a été proposée dans l'article cité ci-dessus pour distinguer un accumulateur au Ni-Cd possédant une masse interne ferromagnétique à d'autres piles telles que les piles au Zn-Carbone, Zn-MnO$_2$ ou Zn-Mercure dont la masse interne n'est pas ferromagnétique. Ce tri partiel était ensuite suivi par un tri supplémentaire basé sur les rayons X.

L'analyse des propriétés magnétiques d'un corps métallique est possible par la mesure de la variation d'un champ magnétique lors du passage de ce corps à travers le champ. Cette méthode, dite "Courants de Foucault" ou "Eddy Current" est largement utilisée dans différent domaines industriels, spécifiquement dans les procédés de tri de l'industrie de boulonnerie, le tri des pièces de monnaie ou autres.

Si le principe de courants de Foucault est fiable pour le tri des pièces métalliques massives, dont la composition est uniforme et homogène dans sa coupe transversale, il l'est moins pour les pièces dont la composition est constituée par des couches concentriques tel que les piles ou accumulateurs.

Dans le principe des courants de Foucault, la variation du champ magnétique mesuré dépend essentiellement de la composition de la couche extérieure de la pièce à analyser. Cet effet est bien connu sous le nom de "l'effet de peau". Or, dans la plupart des piles et accumulateurs, la couche extérieure est constituée par une enveloppe en acier, dont l'épaisseur varie, entre différentes marques, de 0,15 à 0,35 mm. A cause de cette variation de l'épaisseur de l'enveloppe, et à cause de l'effet de peau lié à la méthode, les inversions de réponse sont souvent observées lors de l'utilisation des appareils existants, basés sur le principe des courants de Foucault, pour séparer les accumulateurs au Ni-Cd des autres piles au Zinc.

Etant donné que la profondeur de pénétration d'un champ magnétique à travers un corps métallique est directement proportionnelle à l'inverse de la racine carrée de la fréquence du champ, il serait possible d'atténuer l'effet de peau lié au principe des courants de Foucault en utilisant un champ magnétique à basse fréquence. Ceci permettrait de mieux analyser les propriétés ferromagnétiques de la masse interne de la pile ou de l'accumulateur. Malgré cette amélioration, les appareils de mesure existants basés sur la principe des courants de Foucault donnent toujours une réponse intégrale, proportionnelle à la masse totale des matériaux ferromagnétiques de la pièce à analyser. Appliquée au tri des piles et accumulateurs usagés, cette réponse intégrale ne permet pas de distinguer une pile au zinc possédant une enveloppe d'acier de forte épaisseur d'un accumulateur au Ni-Cd possédant une mince enveloppe. Dans certains cas donc, l'effet ferromagnétique de l'enveloppe épaisse d'une pile au zinc est plus grand ou égal à l'effet additionné de l'enveloppe et de la masse interne d'un accumulateur au Ni-Cd.

D'autre part, la détermination de la masse ferromagnétique totale par une mesure globale exige un tri mécanique très poussé pour séparer les piles et accumulateurs usagés selon leur dimension exacte.

A ce jour, aucun procédé de tri automatique n'est suffisemment fiable pour être applicable à l'échelle industrielle, notamment pour des mélanges de piles et accumulateurs usagés collectés de manière non-sélective.

Le meilleur schéma de tri proposé actuellement est un compromis de différentes méthodes semi-automatiques et manuelles (*Lindhqvist T. & Christansen K. : Collection and sorting of used batteries - University of Lund (Sweden) - 20 Jan 1990*). Ce schéma de tri comprend plusieurs étapes successives et peut être résumé de la manière suivante:
- Tri mécanique pour séparer des éléments dont le diamètre est plus grand que 37 mm.
- Tri mécanique pour séparer des éléments de diamètre inférieur à 37 mm en plusieurs groupes selon chaque dimension standard.
- Pour chaque dimension standard, les éléments au Zn-Carbone, au Pb-Acide et au Mercure sont séparés par une mesure de poids spécifique.
- Pour chaque dimension standard, les piles alcalines Zn-MnO$_2$ et les accumulateurs au Ni-Cd sont séparés par la mesure de la vitesse de propagation des ultrasons.
- Les pièces de dimension non-standard, ou de diamètre supérieur à 37 mm, sont triées manuellement.

Description de l'Invention

La présente invention a pour objet un procédé simple permettant de trier et de séparer automatiquement les piles ou accumulateurs usagés selon leur nature chimique. En particulier, l'invention a pour objet un procédé et un dispositif d'analyse des piles ou accumulateurs usagés afin de permettre la détermination de leur nature chimique. Le procédé et les équipements propres à cette invention permettent de trier et de séparer d'une manière rapide, fiable et économique les piles ou accumulateurs usagés selon leur nature chimique, quels que soient leur forme, leurs dimensions ou leur état.

La présente invention propose un procédé de tri des piles et accumulateurs usagés de différentes tailles, dimensions et natures chimiques comprenant une étape de tri mécanique basée sur la forme et les dimensions et une étape de tri électromagnétique basée sur l'analyse d'une image ferromagnétique de la pile ou de l'accumulateur.

Le nouveau procédé et dispositif de mesure électromagnétique permet d'éliminer l'effet prédominant de l'enveloppe d'acier des piles ou accumulateurs, et peut effectuer le tri d'un mélange de différentes piles ou accumulateurs ayant des dimensions similaires.

Un schéma de tri, basé sur l'analyse statistique des piles et accumulateurs usagés collectés et sur les exigences de leurs traitements subséquents est également proposé. L'optimisation du schéma de tri permet de simplifier les procédures de tri et les équipements utilisés, tout en respectant les exigences de pureté des procédés de traitements sélectifs subséquents.

Le procédé et les équipements de tri proposés par cette invention présentent comme avantage la simplicité, la fiabilité, la rapidité et une exploitation économique.

Le procédé de tri selon l'invention est caractérisé en ce que l'étape de tri chimique comporte l'élaboration, par passage d'une pile ou d'un accumulateur au travers d'un champ magnétique à une vitesse constante ± 10%, d'une réponse inductive à deux composantes. L'une de ces composantes est représentative de la masse ferromagnétique de la pile ou de l'accumulateur, l'autre représentative de la distribution de la masse ferromagnétique dans celle-ci ou celui-ci. Ceci permet l'élaboration d'un signal de contrôle de tri basé sur la reconnaissance, soit de l'amplitude de ces deux composantes, soit de l'amplitude de l'un de ces composants. Ainsi, toutes les sortes de piles et accumulateurs peuvent être triées d'une manière simple et efficace.

L'élaboration de la réponse inductive à deux composantes s'effectue de préférence par:
- le déplacement de piles ou accumulateurs à travers le champ magnétique à une vitesse constante à ± 10 % par un moyen de transport, de préférence avec un axe de symétrie de la pile ou de l'accumulateur parallèle à l'axe de déplacement;
- le captage du flux électrique induit crée par les piles ou accumulateurs par un capteur inductif; et
- le traitement du signal du capteur inductif pour produire un signal correspondant à la masse ferromagnétique et à sa distribution selon l'axe de déplacement.

Dans le procédé selon l'invention, le déplacement des piles ou des accumulateurs à une vitesse constante est importante afin d'assurer une reconnaissance fiable à partir de la réponse inductive à deux composantes. Cette vitesse est habituellement entre 0,2 et 2,0 m/s, de préférence entre 0,5 et 1 m/s. Contrairement aux méthodes connues utilisant les courants de Foucault, où la vitesse des piles ou des accumulateurs n'est pas critique, selon l'invention une vitesse constante est imposée, de préférence par une bande transporteuse à vitesse réglable. La chute simple des pièces n'est pas recommandable à moins de prendre des précautions afin d'éviter les variations de vitesse dues aux états des surfaces.

Avantageusement, le captage du flux s'effectue avec un capteur inductif présentant au moins une bobine, par laquelle les piles ou accumulateurs passent, de préférence par un axe parallèle à l'axe de la bobine et on emploie un champ magnétique variable produit au moyen d'un circuit d'excitation.

De cette manière, on peut soumettre certaines piles ou accumulateurs à deux mesures inductives différentes par la fréquence et/ou la tension d'excitation d'un circuit d'excitation du champ magnétique, et/ou par la vitesse de déplacement.

On peut également soumettre certaines piles ou accumulateurs à un premier tri basé sur la reconnaissance d'une seule composante d'une première réponse inductive, suivie, pour une partie des piles ou accumulateurs ainsi triées, d'un second tri basé sur les deux composantes d'une seconde réponse inductive.

Par exemple, un lot de piles ou d'accumulateurs mélangés peut être trié une première fois en utilisant seulement la masse ferromagnétique totale comme critère de tri. Ce premier tri permet de séparer le mélange en trois lots : un premier lot groupant les piles à base de zinc (Zn-C ou Zn-MnO$_2$) avec une enveloppe standard; un deuxième lot groupant les piles au Mercure; et un troisième lot groupant les accumulateurs Ni-Cd et les piles alcalines Zn-MnO$_2$ avec une enveloppe épaisse.

Le troisième lot nécessite donc un deuxième tri avec une fréquence de champ d'excitation plus basse, et/ou avec une vitesse de passage plus lente pour élaborer l'image ferromagnétique de la pile ou de l'accumulateur. Le critère de tri de cette deuxième étape est basé sur les deux composantes de l'image ferromagnétique de la pile ou de l'accumulateur.

Cette manière de procéder présente l'avantage de trier rapidement le 70 à 80 % des piles à base de zinc ou les piles au Mercure standard. Le 20 à 30 % des piles alcalines non-standard mélangées avec les accumulateurs Ni-Cd sont séparées par une deuxième étape plus lente.

Selon un schéma de tri :
- l'étape de tri mécanique comporte le tri en plusieurs groupes de piles et/ou accumulateurs de forme et de dimensions semblables;
- l'étape de tri chimique par élaboration de réponse inductive à deux composantes s'effectue, soit pour tous les groupes, soit pour certains groupes nécessitant ce tri chimique, les autres groupes n'étant pas assujettis à ce tri chimique; et
- l'étape de tri chimique est suivie par le regroupement de toutes les piles et accumulateurs, assujettis ou non au tri chimique, en groupes dont la composition chimique est adaptée au traitement pour la récupération des métaux.

D'autres caractéristiques du procédé et de l'installation de tri sont élaborées dans les revendications et dans la description qui suit. L'invention concerne également un dispositif de mesure des propriétés ferromagnétiques des piles ou accumulateurs usagés dans ce procédé de tri, comportant un circuit d'excitation destiné à produire un champ magnétique, des moyens pour déplacer les piles ou accumulateurs à travers ce champ magnétique à une vitesse constante à ± 10 %, un capteur du flux électrique induit crée par les piles ou les accumulateurs lorsqu'ils traversent ce champ, et des moyens de traitement du signal du capteur pour produire une réponse inductive à deux composantes, l'une représentative de la masse ferromagnétique de la pile ou de l'accumulateur, l'autre représentative de la distribution de la masse ferromagnétique dans celle-ci ou celui-ci. Ce dispositif peut incorporer tous les détails décrits ci-après.

Description des Dessins

Dans les dessins ci-annexés :
- La Figure 1 illustre un exemple de distribution statistique des piles et des accumulateurs usagés;
- La Figure 2 est un schéma d'une installation de tri selon l'invention;
- La Figure 3 est un diagramme représentant cette installation;
- Les Figures 4a, 4b et 4c représentent les coupes d'une pile Zinc-Carbone, d'une pile alcaline et d'un accumulateur au Ni-Cd;
- La Figure 5 est un schéma d'un dispositif de mesure des spectres ferromagnétiques;
- La Figure 6 représente les courbes de réponse inductive du dispositif de mesure de la Figure 5;
- Les Figures 7 et 8 représentent schématiquement les courbes de réponse inductive de différents types de piles ou accumulateurs de différentes marques, obtenues par le traitement du signal de réponse du dispositif de mesure de la Figure 5;

- La Figure 9 représente schématiquement une unité de tri avec un dispositif de mesure des réponses inductives à deux composantes; et
- La Figure 9a représente un détail de l'unité de tri de la Figure 9.

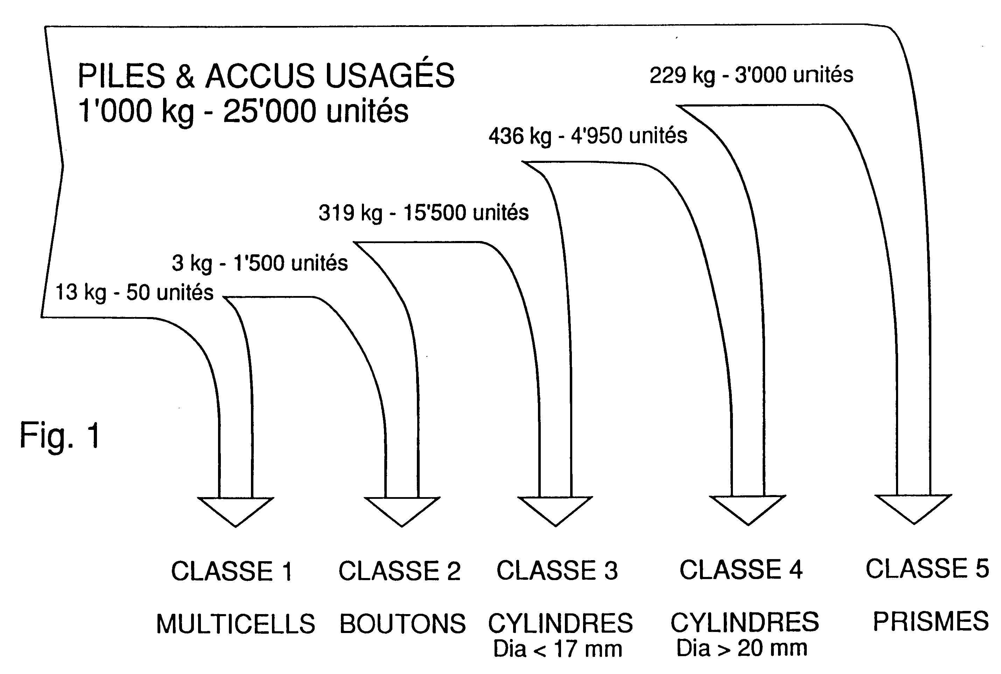

L'analyse statistique présentée dans la Figure 1 et le Tableau I montre qu'en se basant sur leur forme et leurs dimensions, les piles et accumulateurs usagés collectés auprès du public peuvent être divisés en cinq classes de taille et de forme similaires, énumérées à la revendication 9.

## TABLEAU I

| | CLASSE 1 MULTICELLS | CLASSE 2 BOUTONS | CLASSE 3 CYLINDRES (petit) | CLASSE 4 CYLINDRES (grand) | CLASSE 5 PRISMES |
|---|---|---|---|---|---|
| FORME | BLOCS PRISMATIQUES | BOUTONS | CYLINDRES dia < 17 mm | CYLINDRES dia > 20 mm | PRISMES |
| Dimensions (mm) Longueur Larg. / Diam Epaisseur | 160  75 95  65 50  25 | 6.5  12-15  20 3.0  5-6  1.5 | 30-50 50 17 25 10-11 15 16 16 | 45-50  60-100 22-25  32-34 | 50 57 64 75 26 15 62 42 17 15 22 22 |
| Poids (g) | 2000  250 | 0.7  2-4  1.5 | 5-12 23 14 19 | 40-75  100-150 | 50 25 130 90 |
| Chimie | Zn/C, Pb/Acide Ni/Cd, Zn/MnO$_2$ | Hg, Zn/Air, Zn/Mn, Ag, Li, Ni/Cd | Zn/Mn, Zn/C, Ni/Cd, Ni/H$_2$ Hg, Ag, Li | Zn/Mn, Zn/C, Ni/Cd | Zn/C, Zn/Mn, Ni/Cd, Li |
| Statistique (% p.) Zn-Mn Zn-C Zn-Air Hg Ag Li Pb/Acide Ni/Cd & Ni/H$_2$ | 0-5 55-80 0 0 0 0 35-15 5-10 | 20-30 0 5-15 40-60 5-10 2-5 0 < 0.5 | 50-60 30-40 0 < 0.1 < 0.1 < 0.1 0 5-10 | 60-70 20-30 0 0 0 0 0 5-10 | 15-25 70-80 0 0 0 1-2 0 0.1-0.15 |

EP 0 578 688 B1

Etant donné les exigences des procédés existants pour le traitement sélectif des piles et accumulateurs usagés se limitant à 1 % du poids des éléments étrangers, le schéma de tri suivant est proposé :

- Classe 1 : Blocs en assemblage (dit "multicells"). Un tri suivant la nature chimique est nécessaire pour séparer en trois lots d'accumulateurs de Ni-Cd et/ou Ni-Hydrogène, accumulateurs de Pb-Acide et des piles au Zn-Carbone ou Zn-MnO$_2$.
- Classe 2 : Piles et accumulateurs en forme de boutons. Etant donné son faible pourcentage dans la masse totale, seule l'élimination du Mercure nécessite un traitement sélectif des piles boutons. Donc, aucun tri suivant la nature chimique n'est nécessaire. Les piles et accumulateurs en forme de boutons peuvent être dirigés directement au lot de pile de Mercure.
- Classe 3 : Piles et accumulateurs cylindriques de diamètre jusqu'à 20 cm, de préférence égal ou inférieur à 17 mm. Un tri suivant la nature chimique est nécessaire pour séparer en trois lots des accumulateurs au Ni-Cd ou Ni-Hydrogène, des piles au Mercure et des piles au zinc. Etant donné les faibles pourcentages des autres types de piles (Li-MnO$_2$, Zn-AgO, etc...), leur séparation n'est pas nécessaire. Ces types de piles peuvent être dirigés vers le lot des piles au zinc.
- Classe 4 : Piles et accumulateurs cylindriques de diamètre supérieur ou égal à 20 mm. Un tri suivant la nature chimique est nécessaire pour séparer les accumulateurs au Ni-Cd des piles au zinc.
- Classe 5 : Piles et accumulateurs de forme prismatique. Etant donné les faibles pourcentages des éléments au Ni-Cd, au Li-MnO$_2$ ou autres, un tri suivant la nature chimique n'est pas nécessaire. Ces éléments peuvent être dirigés vers le lot des piles au zinc.

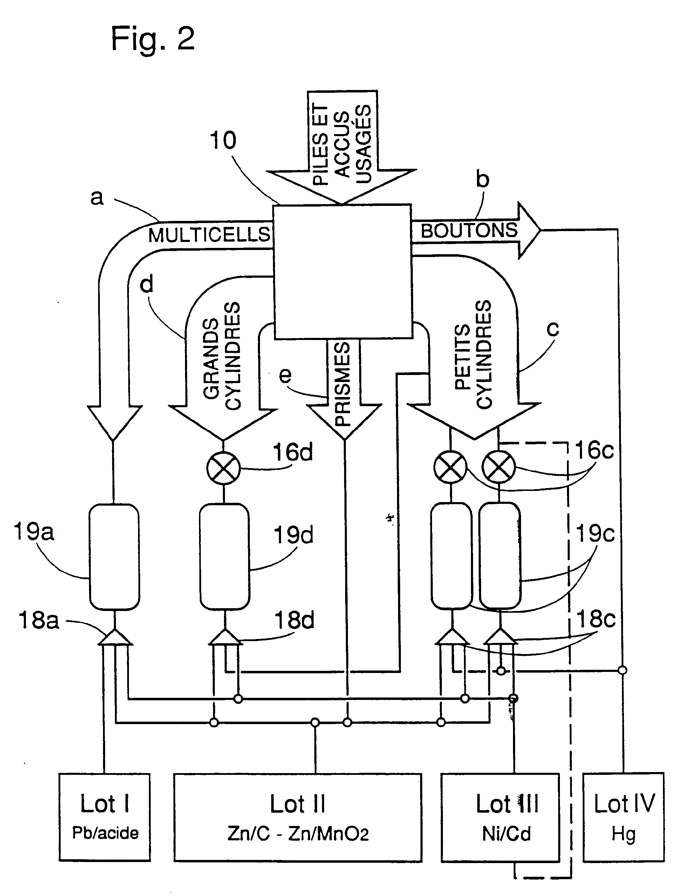

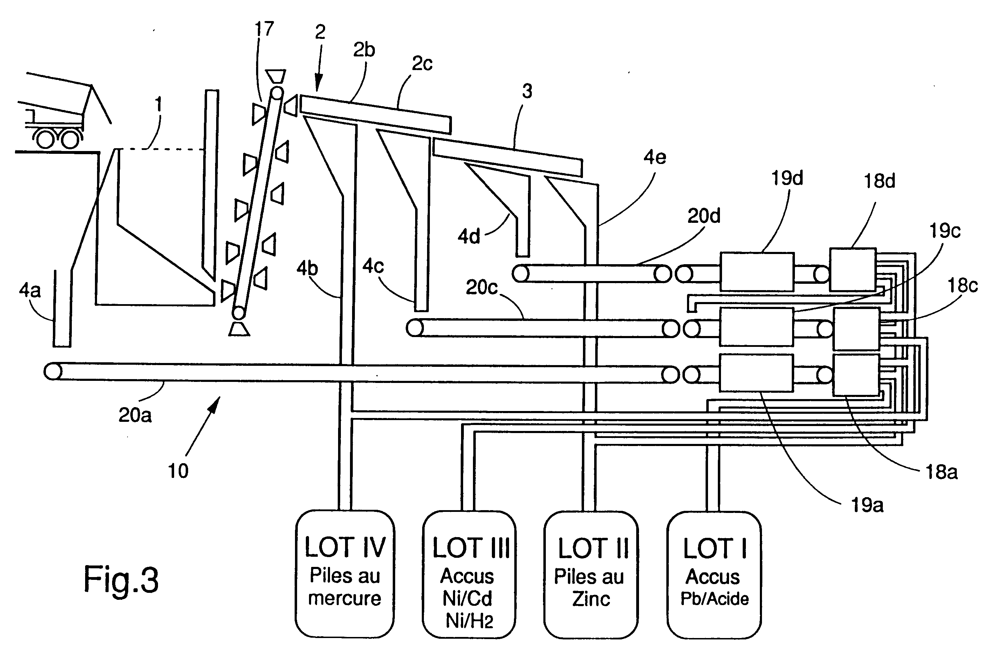

La Figure 2 représente les flux de tri selon le schéma de tri proposé, pour une capacité nominale de une tonne (= 25'000 unités) par heure. Les piles et accumulateurs subissent d'abord un tri selon leurs formes et leurs dimensions dans une unité de tri mécanique 10, représentée plus en détail dans la Figure 3. A la sortie de l'unité 10, il y a un débit a de multicells d'environ 50 unités/heure, un débit b de boutons d'environ 1'500 unités/heure, un débit c de petits cylindres d'environ 15'500 unités/heure, un débit d de grands cylindres d'environ 4'950 unités/heure, et un débit e de prismes d'environ 3'000 unités/heure. Les débits a, c et d sont soumis à un tri selon la composition chimique par des dispositifs de mesure électromagnétiques 19a, 19c et 19d suivis de dispositifs de sortie à trois voies 18a, 18c et 18d respectivement.

A l'entrée des dispositifs de mesure électromagnétiques 19c, 19d, les piles ou accumulateurs passent par un dispositif de distribution 16c, 16d agencé pour aligner les piles ou accumulateurs dans l'axe du dispositif 19c, 19d. Vu que le débit a de multicells est faible et que les multicells se présentent sous des formes diverses, leur alignement peut se faire manuellement.

Les dispositifs de sortie 18a, 18c et 18d aiguillent les piles et accumulateurs vers les lots I à IV selon la composition chimique. Dans le cas du débit d de grands cylindres, la troisième voie du dispositif de sortie 18d renvoie des petits cylindres au débit c. Le débit b de boutons est dirigé directement vers le lot IV de piles au Mercure, et le débit e de prismes est dirigé directement vers le lot II de piles au zinc. Il est possible, comme indiqué en pointillé, de faire subir aux piles du lot III un deuxième tri dans l'unité 19c pour séparer les piles Ni-Cd et Ni-H$_2$.

Après l'opération de tri, le mélange de piles ou accumulateurs usagés est séparé en quatre groupes ou lots, pour les traitements suivants :

Lot I composé des accumulateurs au Pb-Acide de différentes tailles. Ces accumulateurs seront broyés, les parties du container en plastique et de la masse active en plomb ou en composés à base de plomb seront séparés par flottation, au par d'autres moyens. La masse active est dissoute dans l'acide fluoroborique, et le plomb métallique est récupéré par électrolyse sous forme de dépôt cathodique.

Lot II composé des piles au Zn-Carbone ou Zn-MnO$_2$, avec moins de 0,2 à 0,5 % d'autres types de piles telles que Li-MnO$_2$ et/ou Zn-AgO. Ces piles peuvent être traitées par un procédé thermique à 1200-1300°C. La présence des poudres de graphite de la masse active des piles au zinc permet de créer une atmosphère réductrice dans le four. Les composés de zinc sont donc réduits en zinc métallique pour être distillés et séparés en phase vapeur à 700-900°C, L'oxyde de manganèse subit également une réduction, et réagit avec l'enveloppe en fer pour être récupérée sous forme d'un alliage ferro-manganèse. Les autres éléments sont répartis dans la masse de zinc et de ferro-manganèse sous forme d'impuretés avec une concentration maximale entre 0,0005 à 0,0050 %.

Lot III composé des accumulateurs au Ni-Cd et Ni-Hydrogène. Ces derniers représentent usuellement entre 0,5 à 2,0 % de la masse totale de ce groupe. Ces accumulateurs sont également traités par un procédé thermique entre 1000-1200°C. Pour créer une atmosphère réductrice, une quantité de poudres de graphite est mélangée avec ces accumulateurs. Les composés de cadmium sont réduits à l'état métallique pour être distillés et séparés en phase vapeur à 700-900°C. Les composés de nickel subissent également une réduction et réagissent avec l'enveloppe en fer pour être récupérés sous forme d'un alliage ferro-nickel.

Lot IV composé de 30 à 50 % de piles au Mercure mélangées avec d'autres types de tels que Zn-Air, Li-

MnO$_2$, Zn-MnO$_2$ ou Ni-Cd. Ce lot est traité thermiquement entre 400 et 600°C. Le Mercure est séparé par distillation. La masse restante, qui représente entre 15 et 30 Kg par tonne de piles ou accumulateurs usagés traités est mélangée avec le Lot II pour le traitement final.

Equipement de tri mécanique

La Figure 3 représente schématiquement l'unité de tri mécanique 10 d'une installation de tri selon l'invention.

A l'entrée, le mélange de piles et accumulateurs collectés est déversé sur un tamis 1, dont le passage est de 40 mm x 70 mm. Ce tamis permet de retenir les blocs en assemblage (multicells - Classe 1), dont les dimensions sont supérieures aux orifices de passage. Ce tamis 1 peut être construit sous forme de grille ou de plateau métallique perforé, et peut être soumis à des vibrations pour accélérer la séparation.

Les blocs en assemblage multicells ainsi séparés sont dirigés par gravité par un conduit 4a et par un tapis roulant 20a vers une unité de mesure électromagnétique 19a, pour être séparés selon leur nature chimique par un dispositif de sortie à trois voies 18a.

La fraction des piles et accumulateurs ayant passé à travers le tamis 1 est alors dirigée par un tapis élévateur 17 vers un table vibrante 2 comportant un plan incliné à 20 - 30°. Ce plan incliné est soumis aux vibrations d'un vibrateur électrique dont la fréquence se situe entre 1000 et 2000 Hz, avec une amplitude de 0,5 à 1,0 mm.

Le plan incliné 2 est divisé en deux sections 2b et 2c constituées par des lamelles en acier de 35 à 40 mm de large, de 50 à 150 cm de long et de 1 à 2 mm d'épaisseur. Ces lamelles possèdent deux pliures de 20°, à 5 mm de chaque bord, dans le sens de la largeur.

La section 2b peut être composée de huit à quinze lamelles parallèles espacées entre elles de 7 mm. Cette largeur de fente est calculée pour laisser passer toutes les piles en forme de bouton et retenir, sur le plan incliné 2b, les autres éléments.

Les piles boutons ainsi séparées sont ensuite dirigées par gravité par un conduit 4b et/ou par un tapis roulant vers le lot IV de piles au Mercure.

La fraction restant sur le plan incliné 2b continue son avance sous l'influence des vibrations jusqu'à la section 2c.

La section 2c peut être composée de huit à quinze lamelles espacées entre elles de 18 mm. Cette largeur de fente permet le passage des piles et accumulateurs cylindriques, dont le diamètre est égal ou inférieur à 17 mm. Les éléments de dimensions supérieures sont retenus sur le plan incliné 2.

Les piles ou accumulateurs cylindriques de diamètre égal ou inférieur à 17 mm ainsi séparés sont dirigés par gravité par un conduit 4c et par un tapis roulant 20c et/ou par gravité vers une unité de mesure électromagnétique 19c pour être séparés selon leur nature chimique par un dispositif de sortie à trois voies 18c.

La fraction restante après le passage successif au travers des sections 2b et 2c de la table vibrante 2 se constitue des éléments prismatiques et des éléments cylindriques de diamètre égal ou supérieur à 20 mm. Cette fraction est alors dirigée vers une deuxième table vibrante 3.

La table vibrante 3 est constituée d'un plan plein en acier, incliné dans les deux sens (OX) et (OY). L'inclinaison dans le sens OY est réglable entre 25-30°; l'inclinaison dans le sens OX est réglable entre 15-20°. Le mélange des piles et accumulateurs prismatiques et cylindriques restant est introduit au point le plus haut de la table 3. Des chicanes bien disposées permettent de placer les éléments cylindriques en une position telle que l'axe du cylindre soit orienté dans le sens OY. Sous l'influence des vibrations, le mélange avance dans le sens OY. A la sortie des chicanes, les éléments cylindriques roulent sur eux-mêmes pour avancer dans le sens OX et pour sortir de la table 3 par le côté latéral le plus bas. Les éléments prismatiques se déplacent par glissement dans le sens OY selon la diagonale de la table 3 pour sortir au point le plus bas.

Les piles et accumulateurs cylindriques de diamètre égal ou supérieur à 20 mm ainsi séparés sont dirigés par gravité par un conduit 4d et par un tapis roulant 20d vers une unité de mesure électromagnétique 19d pour être séparés selon leur nature chimique par un dispositif de sortie à trois voies 18d.

Les éléments prismatiques à la sortie de la table vibrante 3 sont ensuite dirigés directement par gravité par un conduit 4e ou par un tapis roulant vers le lot II des piles au zinc.

Mesure Electromagnétique

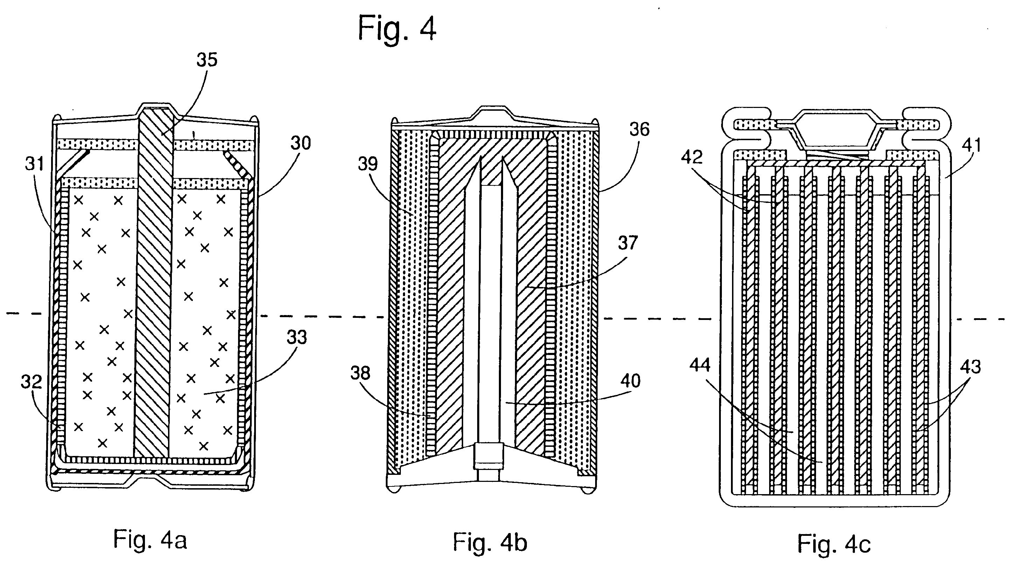

La Figure 4a représente en coupe une pile au zinc-carbone comportant une enveloppe 30 en acier, plastique ou papier, une anode 31 en zinc, un séparateur 32 en matière plastique poreux, une masse cathodique 33 constituée d'un mélange de poudres d'oxyde de manganèse et de carbone avec un électrolyte et un collecteur de courant cathodique 35 en graphite.

9

La Figure 4b représente en coupe une pile alcaline comportant une enveloppe 36 en acier, une masse anodique 37 constituée d'un mélange de poudre de zinc avec un électrolyte, un séparateur 38 en matière plastique poreux, une masse cathodique 39 constituée d'un mélange de poudres d'oxyde de manganèse et carbone avec un électrolyte et un collecteur de courant anodique 40 en laiton.

La Figure 4c représente en coupe un accumulateur au Ni-Cd comportant une enveloppe 41 en acier nickelé, des anodes 42 en cadmium sous forme enroulée, des séparateurs 43 en matière plastique poreuse et des cathodes 44 en feuilles de nickel imprégnées de mélange de poudres d'oxyde de nickel et un électrolyte.

On peut ainsi voir que le contenu des piles à base de zinc (piles au zinc-carbone et alcalines) est constitué par des éléments dits "non-ferromagnétiques". Dans le cas d'un accumulateur au Ni-Cd, la propriété ferromagnétique du contenu est due à la présence des composants à base de nickel. Ainsi, la masse ferromagnétique des piles à base de zinc (y compris la masse d'acier de l'enveloppe) est différente de celle des accumulateurs au Ni-Cd. D'autre part, la masse ferromagnétique des piles au zinc, représentée par leur enveloppe en acier 30, 36, est répartie uniformément et symétriquement par rapport à un axe radial passant par le milieu de la pièce, indiqué par un ligne en pointillé dans la Figure 4a. Dans le cas des accumulateurs au Ni-Cd, cette masse ferromagnétique, représentée par l'enveloppe en acier 41 et les composants internes à base de nickel, n'est pas uniforme et symétrique par rapport à ce même axe radial.

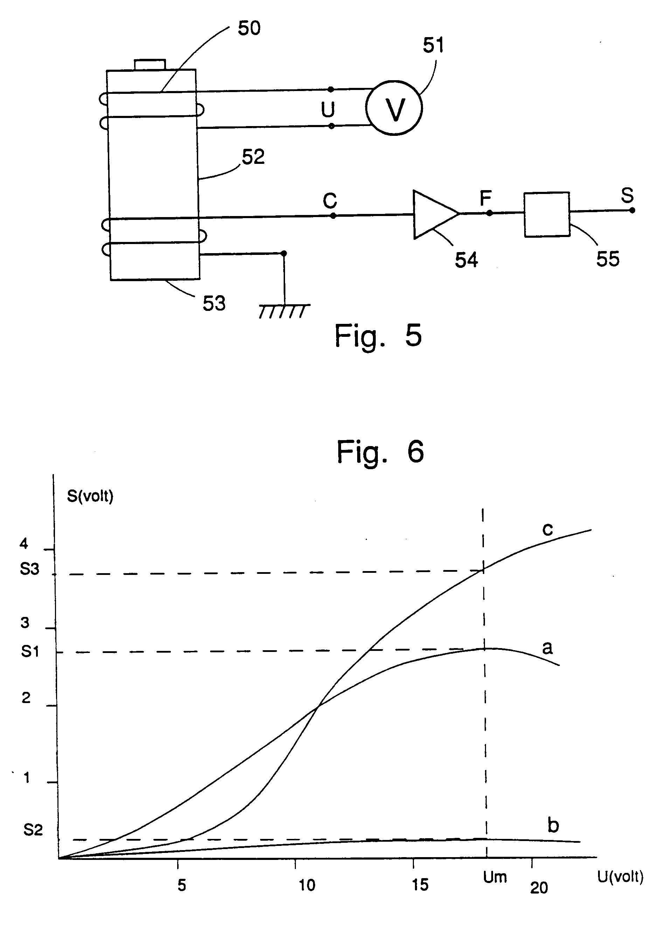

La Figure 5 représente schématiquement un exemple de réalisation du dispositif de mesure selon l'invention. Un circuit d'excitation 50 alimenté par une source de tension variable 51, produit un flux variable traversant la masse de la pile ou de l'accumulateur à analyser 52. La longueur totale axiale du circuit d'excitation 50 doit être inférieure à celle de la pile ou l'accumulateur 52, de préférence entre 1/10 et 1/5 de la longueur de la pièce à analyser.

Suivant la position de la pile ou de l'accumulateur 52 dans le champ magnétique créé par le circuit d'excitation 50, un flux inductif, proportionnel à la masse ferromagnétique de la portion de la pile ou de l'accumulateur 52 soumise au champ magnétique, est capté par un capteur inductif 53 relié aux moyens de traitement 54 et 55. Le moyen de traitement 54 est composé d'un ou de plusieurs amplificateurs sélectifs de tension permettant d'adapter le niveau et la fréquence du signal inductif C à ceux de la tension d'entrée F du moyen de traitement 55. Le moyen de traitement 55 est composé d'un ou de plusieurs filtres actifs ou passifs permettant d'éliminer les interférences indésirables provenant du capteur 53.

Ce dispositif de mesure fournit un signal S à la sortie des moyens de traitement 55 dont l'amplitude est fonction de la masse ferromagnétique de la pile ou de l'accumulateur à analyser 52, qui est soumise au champ du circuit d'excitation 50.

La Figure 6 représente un exemple de l'amplitude du signal S en fonction de la tension U du circuit d'excitation 50, et pour différents types de piles ou accumulateurs placés en position statique dans le champ du circuit d'excitation 50. Dans cette Figure, la courbe (a) représente la réponse S pour une pile alcaline au Zn-MnO$_2$ du type AA∗, la courbe (b) celle d'une pile au Zn-Carbone du type AA et la courbe (c), la réponse d'un accumulateur au Ni-Cd du type AA. Donc, la mesure de l'amplitude du signal S1, S2 ou S3 à une tension Um devrait permettre de déterminer la nature chimique de la pile ou de l'accumulateur à analyser.

En déplaçant la pile ou l'accumulateur à analyser 52 à une vitesse constante dans le champ du circuit d'excitation 50, et en enregistrant l'amplitude du signal S en fonction du temps, on obtient un réponse qui représente la répartition de la masse ferromagnétique de la pile ou de l'accumulateur selon son axe.

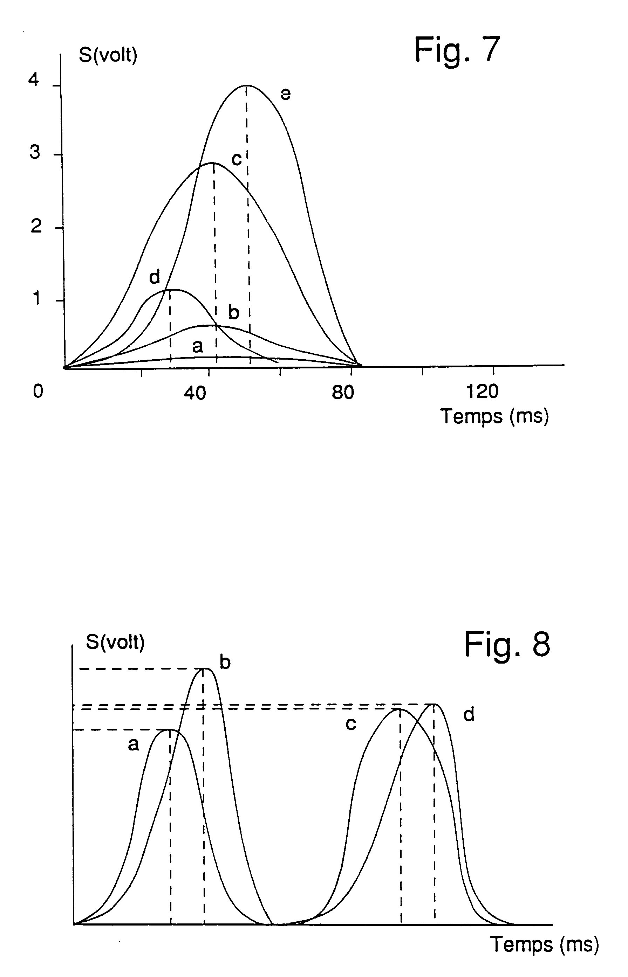

La Figure 7 représente la reconstitution schématique des réponses obtenues par le dispositif de mesure décrit plus haut, respectivement avec une pile au Zn-Carbone du type AA (courbe a), une pile au Li-MnO$_2$ du type AA (courbe b), une pile alcaline au Zn-MnO$_2$ du type AA (courbe c), une pile au Mercure (courbe d) et un accumulateur au Ni-Cd du type AA (courbe e). Les pièces à analyser étaient déplacées à travers le circuit d'excitation 50 à une vitesse constante de 50 cm/seconde.

L'analyse de ces réponses permet d'obtenir différentes grandeurs caractéristiques du type de pile ou d'accumulateur analysé :

- l'amplitude maximale du signal S est proportionnelle à la masse ferromagnétique totale de la pièce à analyser.
- la largeur de la réponse à l'amplitude 0 est proportionnelle à la longueur de la pièce à analyser.
- la position de l'amplitude maximale du signal S, par rapport à la moitié de la largeur de la courbe à l'amplitude 0, constitue un spectre ou l'image ferromagnétique de la pièce à analyser, en d'autres termes la réponse inductive à deux composantes.


∗Type AA désigne des piles ou des accumulateurs cylindriques de 14mm de diamètre et de 50mm de longueur, selon les normes de l'American National Standards Institute ANSI.

Dans les cas considérés comme standards, qui représentent environ 75 à 85 % des cas, la considération de l'une des deux premières caractéristiques est suffisante pour déterminer la nature chimique des piles ou accumulateurs usagés de différentes tailles. Pour les cas "non-standards", la considération d'une des deux premières caractéristiques est insuffisante.

La Figure 8 représente les réponses obtenues avec des piles alcalines au $Zn-MnO_2$ du type AA, de marques différentes (courbes a et c), et avec des accumulateurs au Ni-Cd du type AA, de marques différentes (courbes b et d).

Les courbes a et b représentent les cas standards décrits plus haut. Les courbes c et d représentent les cas non-standards où la pile alcaline au $Zn-MnO_2$ possède une enveloppe en acier de forte épaisseur, et l'accumulateur au Ni-Cd possède une enveloppe très mince. Dans un tel cas, la mesure seule de l'amplitude maximale du signal S conduirait à une erreur sur la détermination de la nature chimique de la pièce à analyser. La comparaison de l'image ferromagnétique, ou la détermination de l'amplitude maximale et de la position de l'amplitude maximale de la courbe, sera par contre un paramètre fiable pour déterminer la nature chimique de la pièce à analyser.

Il est évident que la tension du signal S et sa courbe complète peuvent être codifiés par un traitement logiciel pour optimiser le temps de mesure et d'analyse, qui se situe de préférence entre 0,2 et 0,4 seconde par pièce. Le résultat codifié de l'analyse du signal S ou de sa courbe est utilisée comme commande d'un dispositif électro-pneumatique ou électro-mécanique qui sépare les piles ou accumulateurs selon leur nature, décrit ci-après.

L'Unité de Tri Electromagnétique

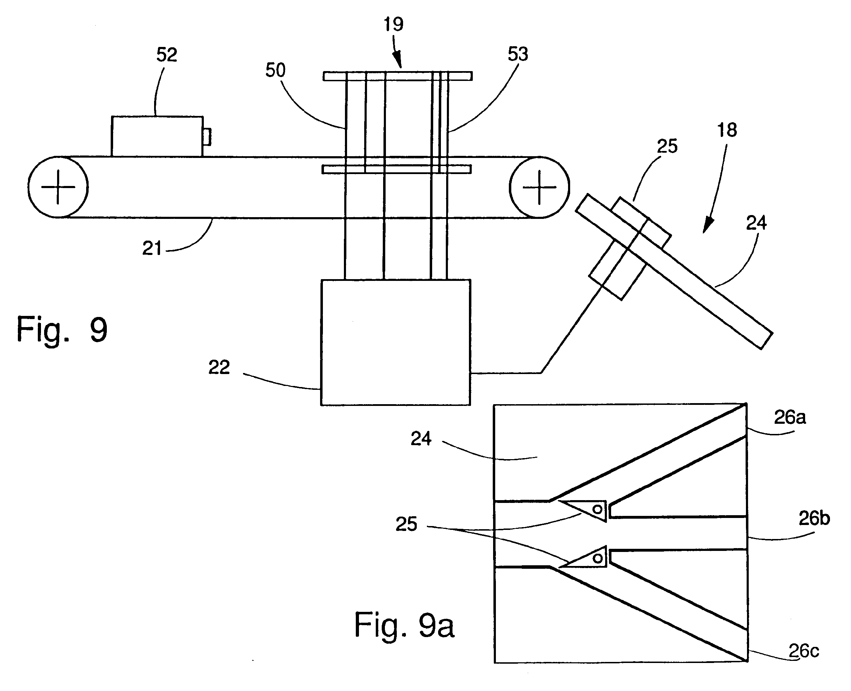

La Figure 9 représente schématiquement l'unité de tri comprenant le dispositif de mesure électromagnétique 19 décrit plus haut, et le dispositif de sortie 18.

Sur un tapis roulant 21, constitué par une matière isolante, non magnétique, les piles ou accumulateurs 52 sortant des sections de tri mécanique 10 sont amenés un à un jusqu'à l'unité de mesure 19. Par un profil spécial du tapis 21, les piles ou accumulateurs 52 sont positionnés de manière à ce que leur axe soit parallèle à celui de l'unité de mesure 19. La vitesse de déroulement du tapis 21 est réglable, par exemple entre 0,5 et 1,5 m/s.

L'unité de mesure 19 est constituée d'un cylindre en matière isolante, non magnétique, dont le diamètre est calculé en fonction des dimensions des piles ou accumulateurs à analyser. En règle générale, sa longueur est égale ou inférieure à la longueur des piles ou des accumulateurs. L'unité de mesure 19 comprend une bobine d'excitation 50 et un capteur inductif 53. La source de tension 51 et les moyens de traitement des signaux 54 et 55 de la Figure 5 sont représentés schématiquement à la Figure 9 par une unité de commande 22, qui possède également un dispositif d'analyse des signaux délivrés par le capteur 53 et les moyens de traitement 54 et 55. Ce dispositif d'analyse donne également un ordre codifié, en fonction du résultat de l'analyse de la courbe de réponse inductive, à un circuit de commande de l'unité de sortie 18. Le dispositif d'analyse peut être un ordinateur central travaillant avec un logiciel adéquat. Il est évident qu'un logiciel simple permet de distinguer les différentes courbes de réponse inductive entre elles, sur la base d'une ou de deux composantes, et ainsi de reconnaître les différents types de piles ou accumulateurs, en utilisant des piles ou des accumulateurs standards comme calibre.

Le dispositif de sortie 18 peut être constitué par un plan incliné 24 avec trois voies de sortie 26a, 26b et 26c, aménagés selon le sens incliné du plan. Deux clapets 25, actionnés par des servo-moteurs, sont placés à la jonction des voies de sortie du plan 24 pour dévier la trajectoire de chute des piles ou accumulateurs 52 vers une des voies de sortie 26a, 26b ou 26c.

A la sortie du dispositif de mesure 19, la pile ou l'accumulateur 52 tombe, à la fin du tapis roulant 21 sur le plan incliné 24 du dispositif de sortie 18. En même temps, le dispositif d'analyse des signaux 22 donne un ordre, qui correspond à ses résultats d'analyse, pour actionner ou non un des clapets 25. Ainsi, en fonction de leur nature chimique, la trajectoire de chute des piles ou accumulateurs 52 est déviée sur une des voies de sortie 26a, 26b ou 26c du plan incliné 24. L'opération de tri est ainsi réalisée.

**Revendications**

1. Procédé de tri de piles et accumulateurs usagés de différentes formes et dimensions et de différentes compositions chimiques, comportant une étape de tri mécanique selon les formes et les dimensions, suivie d'une étape de tri selon la composition chimique basée sur la mesure d'un paramètre physique, caractérisé en ce que l'étape de tri chimique comporte l'élaboration, par passage d'une pile ou d'un accumulateur au travers d'un champ magnétique à une vitesse constante à ± 10 %, d'une réponse inductive à deux composantes, l'une représentative de la masse ferromagnétique de la pile ou de l'accumulateur, l'autre représentative de la distribution de la masse ferromagnétique dans celle-ci ou celui-ci, et l'élaboration d'un signal de contrôle de tri basé sur la reconnaissance, soit de l'amplitude de ces deux composantes, soit de l'amplitude de l'une de ces composantes.

2. Procédé selon la revendication 1, caractérisé en ce que l'élaboration de la réponse inductive à deux composantes s'effectue par:
   - le déplacement de piles ou accumulateurs à travers le champ magnétique à une vitesse constante à ± 10 % par un moyen de transport, de préférence avec un axe de symétrie de la pile ou de l'accumulateur parallèle à l'axe de déplacement;
   - le captage du flux électrique induit créé par les piles ou accumulateurs par un capteur inductif (53); et
   - le traitement du signal du capteur inductif pour produire un signal correspondant à la masse ferromagnétique et à sa distribution selon l'axe de déplacement.

3. Procédé selon la revendication 2, caractérisé en ce que le captage du flux s'effectue avec un capteur inductif présentant au moins une bobine (53), par laquelle les piles ou accumulateurs passent, de préférence par un axe parallèle à l'axe de la bobine.

4. Procédé selon la revendication 2 ou 3, caractérisé en ce qu'un champ magnétique variable est produit au moyen d'un circuit d'excitation (51).

5. Procédé selon la revendication 2 ou 3 ou 4, caractérisé en ce que l'on soumet certaines piles ou accumulateurs à deux mesures inductives différentes, par la fréquence et/ou la tension d'excitation d'un circuit d'excitation du champ magnétique, et/ou par la vitesse de déplacement.

6. Procédé selon la revendication 5, caractérisé en ce que l'on soumet certaines piles ou accumulateurs à un premier tri basé sur la reconnaissance d'une seule composante d'une première réponse inductive, suivie, pour une partie des piles ou accumulateurs ainsi triées, d'un second tri basé sur les deux composantes d'une seconde réponse inductive.

7. Procédé selon n'importe laquelle des revendications 2 à 6, caractérisé en ce que la vitesse de déplacement des piles ou des accumulateurs est située entre 0,2 et 2,0 m/s, de préférence entre 0,5 et 1 m/s.

8. Procédé selon n'importe laquelle des revendications précédentes, caractérisé en ce que:
   - l'étape de tri mécanique comporte le tri en plusieurs groupes de piles et/ou accumulateurs de forme et de dimensions semblables;
   - l'étape de tri chimique par élaboration de réponse inductive à deux composantes s'effectue, soit pour tous les groupes, soit pour certains groupes nécessitant ce tri chimique, les autres groupes n'étant pas assujettis à ce tri chimique; et
   - l'étape de tri chimique est suivie par le regroupage de toutes les piles et accumulateurs, assujettis ou non au tri chimique, en groupes dont la composition chimique est adaptée au traitement pour la récupération des métaux.

9. Procédé selon la revendication 8, caractérisé en ce que l'étape de tri mécanique comporte un groupage en:
   - classe 1, multicells, comportant des piles zinc-carbone et des accumulateurs plomb-acide et nickel-cadmium;
   - classe 2, boutons, comportant des piles au mercure, zinc-air, zinc-manganèse, argent, lithium et des accumulateurs nickel-cadmium;.
   - classe 3, petits cylindres de diamètre jusqu'à 20 cm de préférence jusqu'à 17 cm, comportant des piles zinc-manganèse, zinc-carbone, des accumulateurs nickel-cadmium, nickel-hydrogène, et des piles au mercure, argent et lithium;
   - classe 4, grands cylindres de diamètre à partir d'environ 20 cm, comportant des piles zinc-manganèse, zinc-carbone et nickel-cadmium; et
   - classe 5, prismes, comportant des piles zinc-carbone, zinc-manganèse, lithium, et des accumulateurs nickel-cadmium; et
     l'étape de tri chimique comporte la séparation selon la réponse inductive,

- des unités de la classe 1 aux lots au zinc, au plomb et au nickel;
- des unités de la classe 3 aux lots au zinc, au nickel et au mercure; et
- des unités de la classe 4 aux lots au zinc et au nickel, éventuellement avec un renvoi de petits cylindres à la classe 3.

10. Procédé selon la revendication 9, caractérisé en ce que les unités des classes 1 et 5 sont distribués sans tri chimique:
    - la classe 2 avec les lots au mercure, et
    - la classe 5 avec les lots au zinc.

11. Installation de tri de piles et accumulateurs usagés de différentes formes et dimensions et de différentes compositions chimiques, comportant des moyens de tri mécanique selon les formes et les dimensions (10), suivi des moyens de tri selon la composition chimique sur la base d'une mesure d'un paramètre physique, caractérisée en ce que les moyens de tri chimique comportent :
    - un circuit d'excitation (50, 51) destiné à produire un champ magnétique,
    - des moyens (21) de transport pour déplacer les piles ou les accumulateurs à travers un champ magnétique à une vitesse constante à ± 10 % et de préférence selon un axe de symétrie de la pile ou de l'accumulateur parallèle à l'axe de déplacement,
    - des moyens (53, 54, 55) d'élaboration lors du passage d'une pile ou d'un accumulateur à travers ce champ, d'une réponse inductive à deux composantes, l'une représentative de la masse ferromagnétique de la pile ou de l'accumulateur, l'autre représentative de la distribution de la masse ferromagnétique dans celle-ci ou celui-ci, et
    - des moyens (22) d'élaboration d'un signal de contrôle de tri basé sur la reconnaissance, soit de l'amplitude de ces deux composantes, soit de l'amplitude de l'une de ces composantes.

12. Installation selon la revendication 11, caractérisée en ce que les moyens d'élaboration de réponse inductive à deux composantes comportent un capteur (53) du flux électrique induit créé par les piles ou les accumulateurs lorsqu'ils traversent ce champ, et des moyens de traitement (54, 55) du signal du capteur pour produire un signal correspondant à la masse ferromagnétique et à sa distribution selon l'axe de déplacement.

13. Installation selon la revendication 12, caractérisée en ce que le capteur comporte au moins une bobine (53), par laquelle les piles ou accumulateurs (52) passent, de préférence avec leur axe parallèle à l'axe de la bobine.

14. Installation selon la revendication 12 ou 13, caractérisée en ce que le circuit d'excitation (50, 51) comporte des moyens pour régler sa tension et/ou sa fréquence.

15. Installation selon n'importe laquelle des revendications 11 à 14, caractérisée en ce que les moyens de traitement du signal du capteur inductif comportent au moins un amplificateur de tension (54) et/ou un filtre (55).

16. Installation selon n'importe laquelle des revendications 11 à 15, caractérisée par plusieurs unités de tri chimique (19), chacune associée à des piles et/ou accumulateurs d'une certaine forme et dimension sélectionnés par les moyens de tri mécanique (10), et chacune contrôlant un dispositif de tri (18) à au moins deux voies, de préférence à trois voies.

17. Installation selon n'importe laquelle des revendications 11 à 16, caractérisée par au moins une unité de tri chimique (19) pourvue d'un dispositif de tri qui amène des piles ou des accumulateurs triés par cette unité à une nouvelle mesure de réponse inductive différente, soit par la même unité de tri avec un réglage différent, soit par une unité de tri différente.

18. Installation selon n'importe laquelle des revendications 11 à 17, caractérisée en ce que:
    - les moyens de tri mécanique (10) sont agencés pour trier les piles ou accumulateurs en plusieurs groupes de piles et/ou accumulateurs de forme et de dimensions semblables;
    - les moyens de tri chimique comportant plusieurs unités de tri (19) qui reçoivent, soit tous les groupes, soit certains de ces groupes nécessitant ce tri chimique, les autres groupes n'étant pas assujettis à ce tri chimique; et
    - des chemins de regroupement des piles et accumulateurs, assujettis ou non au tri chimique, en groupes dont la composition chimique est adaptée au traitement pour la récupération des métaux.

19. Dispositif de mesure des propriétés ferromagnétiques des piles ou accumulateurs usagés, dans le procédé de tri selon n'importe laquelle des revendications 1 à 10, le dispositif comportant un circuit d'excitation (50, 51) destiné à produire un champ magnétique, des moyens (21) pour déplacer les piles ou accumulateurs à travers ce champ magnétique à une vitesse constante à ± 10 %, un capteur (53) du flux électrique induit créé par les piles ou les accumulateurs lorsqu'ils traversent ce champ, et des moyens de traitement (54, 55) du signal du capteur pour produire une réponse inductive à deux composantes, l'une représentative de la masse ferromagnétique de la pile ou de l'accumulateur, l'autre représentative de la distribution de la masse ferromagnétique dans celle-ci ou celui-ci.

## Claims

1. A method for sorting used batteries and accumulators of different shapes and dimensions, comprising a mechanical sorting step according to the shapes and dimensions, followed by a chemical sorting step based on the measurement of a physical parameter, characterized in that the chemical sorting step includes generating, by passing a battery or accumulator through a magnetic field at a constant speed ± 10%, a two-component inductive response, one component representing the ferromagnetic mass of the battery or accumulator, the other component representing the distribution of the ferromagnetic mass in the battery or accumulator, and generating a sort-control signal based on the recognition either of the amplitude of these two components, or of the amplitude of one of these components.

2. Method according to claim 1, characterized in that the two-component inductive response is generated by :
   - moving the batteries or accumulators through a magnetic field at a constant, ± 10%, speed by a transport means, preferably with an axis of symmetry of the battery or accumulator parallel to the axis of movement;
   - sensing the induced electrical flux created by the batteries or accumulators by an inductive sensor (53); and
   - processing the inductive sensor's signal to produce a signal corresponding to the ferromagnetic mass and its distribution along the axis of movement.

3. Method according to claim 2, characterized in that the flux is sensed by an inductive sensor having at least one winding (53) through which the batteries or accumulators pass, preferably along an axis parallel to the winding's axis.

4. Method according to claim 2 or 3, characterized in that a variable magnetic field is produced by means of an excitation circuit (51).

5. Method according to claim 2 or 3 or 4, characterized in that certain batteries or accumulators undergo two inductive measurements which have a different frequency and/or a different excitation voltage of the magnetic field's excitation circuit, and/or a different speed.

6. Method according to claim 5, characterized in that certain batteries or accumulators undergo a first sort based on the recognition of a single component of a first inductive response followed, for a part of the thus-sorted batteries or accumulators, by a second sort based on the two components of a second inductive response.

7. Method according to any one of claims 2 to 6, characterized in that the speed of the batteries or accumulators is between 0.2 and 2.0 m/s, preferably between 0.5 and 1 m/s.

8. Method according to any preceding claim, characterized in that :
   - the mechanical sorting step includes sorting into several groups of batteries and/or accumulators of similar shapes and dimensions;
   - the chemical sorting step involving generating a two-component inductive response is carried out either for all of the groups, or for certain groups requiring chemical sorting in which case the other groups are not subjected to this chemical sorting; and
   - the chemical sorting step is followed by regrouping of all the batteries and accumulators, whether or not subjected to chemical sorting, into groups whose chemical composition is adapted for a metal recovery operation.

9. Method according to claim 8, characterized in that the mechanical sorting step includes a grouping into :
   - class 1, multicells, including zinc-carbon batteries and lead-acid and nickel-cadmium accumulators;
   - class 2, button cells, including mercury, zinc-air, zinc-manganese, silver and lithium batteries and nickel-cadmium accumulators;
   - class 3, small cylinders of diameter up to 20cm, preferably up to 17cm, including zing-manganese and zinc-carbon batteries, nickel-cadmium and nickel-hydrogen accumulators, and mercury, silver and lithium batteries;
   - class 4, large cylinders of diameter from above about 20cm, including zinc-manganese, zinc-carbon and nickel-cadmium batteries; and
   - class 5, prisms including zinc-carbon, zinc-manganese and lithium batteries and nickel-cadmium accumulators; and
      the chemical sorting step includes separation, according to the inductive response, of :
   - units from class 1 into zinc, lead and nickel batches;
   - units from class 3 into zinc, nickel and mercury batches; and
   - units from class 4 into zinc and nickel batches, possibly with return of small cylinders into class 3.

10. Method according to claim 9, characterized in that the units from classes 1 and 5 are distributed without chemical sorting :
    - class 2 into the mercury batch; and
    - class 5 into the zinc batch.

11. Installation for sorting used batteries and accumulators of different shapes and dimensions, comprising mechanical sorting means (10) according to the shapes and dimensions, followed by chemical sorting means based on the measurement of a physical parameter, characterized in that the chemical sorting means includes :
    - means (21) for moving the batteries or accumulators through a magnetic field;
    - means (53, 54, 55) for generating during passage of a battery or accumulator through this field a two-component inductive response, one representing the ferromagnetic mass of the battery or accumulator, the other representing the distribution of the ferromagnetic mass in the battery or accumulator; and
    - means (22) for generating a sort-control signal based on the recognition either of the amplitude of these two components, or of the amplitude of one of these components.

12. Installation according to claim 11, characterized in that the means for providing the two-component inductive response include an excitation circuit (50, 51) for producing a magnetic field, means (21) for moving the batteries or accumulators through a magnetic field at a constant $\pm$ 10% speed, preferably with an axis of symmetry of the battery or accumulator parallel to the axis of movement, an inductive sensor (53) of the electric flux induced by the batteries or accumulators when they pass through this field, and means (54, 55) for processing the sensor's signal to produce a signal corresponding to the ferromagnetic mass and its distribution along the axis of movement.

13. Installation according to claim 12, characterized in that the inductive sensor has at least one winding (53) through which the batteries or accumulators pass, preferably along an axis parallel to the winding's axis.

14. Installation according to claim 12 or 13, characterized in that the excitation circuit (50, 51) includes means for adjusting its voltage and/or its frequency.

15. Installation according to any of claims 11 to 14, characterized in that the means for processing the inductive sensor's signal include at least one voltage amplifier (54) and/or a filter (55).

16. Installation according to any of claims 11 to 15, characterized by several chemical sorting units (19) each associated with batteries and/or accumulators of a certain shape and dimension selected by the mechanical sorting means (10), and each controlling an at least two-way, preferably a three-way, sorting device (18).

17. Installation according to any of claims 11 to 16, characterized by at least one chemical sorting unit (19) having a sorting device that delivers the batteries or accumulators sorted by this unit to a new and different inductive response measurement by the same sorting unit with a different setting or by a different sorting unit.

18. Installation according to any of claims 11 to 17, characterized in that :
    - the mechanical sorting means (10) are arranged to sort batteries or accumulators into several groups of batteries and/or accumulators of similar shapes and dimensions; and
    - the chemical sorting means includes several sorting units (19) which receive either all of the groups, or certain groups requiring chemical sorting in which case the other groups are not subjected to this chemical sorting;
    - there being paths regrouping all the batteries and accumulators, whether or not subjected to chemical sorting, into groups whose chemical composition is adapted for a metal recovery operation.

19. A device for measuring the ferromagnetic properties of used batteries or accumulators in the sorting method according to any of claims 1 to 10, this device including an excitation circuit (50, 51) for producing a magnetic field, means (21) for moving the batteries or accumulators through a magnetic filed at a constant $\pm 10\%$ speed, an inductive sensor (53) for the electric flux induced by the batteries or accumulators when they pass through this field, and means (54, 55) for processing the sensor's signal to produce a two-component inductive response, one component representing the ferromagnetic mass of the battery or accumulator, the other component representing the distribution of the ferromagnetic mass in the battery or accumulator.

## Patentansprüche

1. Verfahren zum Sortieren von verbrauchten Batterien und Akkumulatoren unterschiedlicher Formen und Abmessungen und unterschiedlicher chemischer Zusammensetzung, einen Schritt zum mechanischen Sortieren nach Formen und Größen enthaltend, gefolgt von einem Schritt zum Sortieren nach chemischer Zusammensetzung auf der Grundlage der Messung einer physikalischen Größe, dadurch gekennzeichnet, daß der chemische Sortierschritt durch den Durchgang einer Batterie oder eines Akkumulators durch ein Magnetfeld mit einer auf $\pm 10\%$ konstanten Geschwindigkeit eine Induktionsantwort mit zwei Komponenten erzeugt, von denen die eine die ferromagnetische Masse der Batterie oder des Akkumulators angibt und die andere die Verteilung der ferromagnetischen Masse darin, und daß er ein Sortiersteuersignal aufgrund der Erkennung entweder der Amplitude dieser beiden Komponenten oder der Amplitude einer dieser Komponenten erzeugt.

2. Verfahren nach Patentanspruch 1, dadurch gekennzeichnet, daß die Erzeugung der Induktionsantwort mit zwei Komponenten erfolgt durch:
    - die Bewegung von Batterien oder Akkumulatoren durch das Magnetfeld mit einer auf $\pm 10\%$ konstanten Geschwindigkeit durch ein Fördermittel, wobei vorzugsweise die Symmetrieachse der Batterie oder des Akkumulators parallel zur Achse der Bewegung ist,
    - die Aufnahme des induzierten elektrischen Flusses, den die Batterien oder Akkumulatoren erzeugen, durch einen Induktionsaufnehmer (53), und
    - die Verarbeitung des Signals des Induktionsaufnehmers zur Erzeugung eines Signales, daß der ferromagnetischen Masse und ihrer Verteilung längs der Bewegungsachse entspricht.

3. Verfahren nach Patentanspruch 2, dadurch gekennzeichnet, daß die Aufnahme des Flusses mit einem Induktionsaufnehmer erfolgt, der mindestens eine Spule (53) aufweist, durch die die Batterien oder Akkumulatoren vorzugsweise längs einer Achse hindurchgehen, die zur Achse der Spule parallel ist.

4. Verfahren nach Patentanspruch 2 oder 3, dadurch gekennzeichnet, daß mittels eines Erregerkreises (51) ein veränderliches Magnetfeld erzeugt wird.

5. Verfahren nach Patentanspruch 2 oder 3 oder 4, dadurch gekennzeichnet, daß bestimmte Batterien oder Akkumulatoren zwei durch die Erregerfrequenz und/oder -spannung eines Erregerkreises des magnetischen Feldes und/oder durch die Geschwindigkeit der Bewegung unterschiedlichen Induktionsmessungen unterzogen werden.

6. Verfahren nach Patentanspruch 5, dadurch gekennzeichnet, daß bestimmte Batterien oder Akkumulatoren einer ersten Sortierung unterzogen werden, die auf der Erkennung nur einer Komponente einer ersten Induktionsantwort beruht, für einen Teil der so sortierten Batterien oder Akkumulatoren gefolgt von einer zweiten Sortierung aufgrund der beiden Komponenten einer zweiten Induktionsantwort.

7. Verfahren nach irgendeinem der Patentansprüche 2 bis 6, dadurch gekennzeichnet, daß die Geschwindigkeit der Bewegung der Batterien oder der Akkumulatoren zwischen 0,2 und 2,0 m/s, vorzugsweise zwischen 0,5 und 1 m/s, liegt.

8. Verfahren nach irgendeinem der vorangehenden Patentansprüche, dadurch gekennzeichnet, daß
   - der Schritt zum mechanischen Sortieren die Sortierung in mehrere Gruppen von Batterien und/oder Akkumulatoren ähnlicher Form und Abmessungen umfaßt,
   - der Schritt zum chemischen Sortieren durch Erzeugung einer Induktionsantwort mit zwei Komponenten entweder an allen Gruppen erfolgt oder an bestimmten Gruppen, die diese chemische Sortierung erfordern, wobei die anderen Gruppen nicht der chemischen Sortierung unterworfen werden, und
   - der Schritt zum chemischen Sortieren von der Gruppierung aller Batterien und Akkumulatoren, seien sie der chemischen Sortierung unterworfen worden oder nicht, in Gruppen gefolgt wird, deren chemische Zusammensetzung der Aufbereitung zur Rückgewinnung der Metalle entspricht.

9. Verfahren nach Patentanspruch 8, dadurch gekennzeichnet, daß der mechanische Sortierschritt eine Gruppierung umfaßt in:
   - Klasse 1: "multicells", umfassend Kohle-Zink-Elemente und Blei-Säure- und Nickel-Cadmium-Akkumulatoren;
   - Klasse 2: Knopfzellen, umfassend Quecksilber-, Zink-Luft-, Zink-Mangan-, Silber-, Lithiumbatterien und Nickel-Cadmium-Akkumulatoren;
   - Klasse 3: kleine Zylinder mit Durchmessern bis zu 20 cm, vorzugsweise bis zu 17 cm, umfassend Zink-Mangan-Batterien, Kohle-Zink-Elemente, Nickel-Cadmium-, Nickel-Wasserstoff-Akkumulatoren und Quecksilber-, Silber- und Lithiumbatterien;
   - Klasse 4: große Zylinder mit Durchmessern ab ungefähr 20 cm, Kohle-Zink-Elemente, Zink-Mangan- und Nickel-Cadmium-Batterien umfassend; und
   - Klasse 5: Prismen, umfassend Kohle-Zink-Elemente, Zink-Mangan-, Lithiumbatterien und Nickel-Cadmium-Akkumulatoren; und
   daß der Schritt des chemischen Sortierens die Trennung entsprechend der Induktionsantwort umfaßt
   - der Stücke der Klasse 1 nach Posten, die Zink enthalten bzw. Blei bzw. Nickel,
   - der Stücke der Klasse 3 nach Posten, die Zink enthalten bzw. Nickel bzw. Quecksilber, und
   - der Stücke der Klasse 4 nach Posten, die Zink enthalten bzw. Nickel, gegebenenfalls mit einer Rückführung kleiner Zylinder in die Klasse 3.

10. Verfahren nach Patentanspruch 9, dadurch gekennzeichnet, daß die Stücke der Klassen 2 und 5 ohne chemische Sortierung verteilt werden:
    - die Klasse 2 mit den Posten, die Quecksilber enthalten, und
    - die Klasse 5 mit den Posten, die Zink enthalten.

11. Anlage zum Sortieren von verbrauchten Batterien und Akkumulatoren unterschiedlicher Formen und Abmessungen und unterschiedlicher chemischer Zusammensetzung, mechanische Mittel zum Sortieren nach Formen und Größen (10) enthaltend, gefolgt von Mitteln zum Sortieren nach chemischer Zusammensetzung auf der Grundlage der Messung einer physikalischen Größe, dadurch gekennzeichnet, daß die Mittel zum chemischen Sortieren enthalten:
    - einen Erregerkreis (50, 51) zur Erzeugung eines Magnetfeldes,
    - Fördermittel (21) zum Bewegen der Batterien oder Akkumulatoren durch ein Magnetfeld mit einer auf ±10% konstanten Geschwindigkeit und vorzugsweise bei zur Symmetrieachse der Batterie oder des Akkumulators paralleler Bewegungsachse,
    - Mittel (53, 54, 55), die bei Durchgang einer Batterie oder eines Akkumulators durch dieses Magnetfeld eine Induktionsantwort mit zwei Komponenten erzeugen, von denen die eine die ferromagnetische Masse der Batterie oder des Akkumulators angibt und die andere die Verteilung der ferromagnetischen Masse darin, und
    - Mittel (22), die ein Sortiersteuersignal aufgrund der Erkennung entweder der Amplitude dieser beiden Komponenten oder der Amplitude einer dieser Komponenten erzeugen.

**12.** Anlage nach Patentanspruch 11, dadurch gekennzeichnet, daß die Mittel zur Erzeugung der Induktionsantwort mit zwei Komponenten einen Aufnehmer (53) des induzierten elektrischen Flusses enthalten, den die Batterien oder Akkumulatoren erzeugen, wenn sie durch dieses Feld hindurchgehen, und Mittel zur Verarbeitung (54, 55) des Signals des Aufnehmers zur Erzeugung eines Signales, daß der ferromagnetischen Masse und ihrer Verteilung längs der Bewegungsachse entspricht.

**13.** Anlage nach Patentanspruch 12, dadurch gekennzeichnet, daß der Aufnehmer mindestens eine Spule (53) aufweist, durch die die Batterien oder Akkumulatoren (52) hindurchgehen, wobei ihre Achse vorzugsweise zur Achse der Spule parallel ist.

**14.** Anlage nach Patentanspruch 12 oder 13, dadurch gekennzeichnet, daß der Erregerkreis (50, 51) Mittel zur Regelung seiner Spannung und/oder seiner Frequenz enthält.

**15.** Anlage nach irgendeinem der Patentansprüche 11 bis 14, dadurch gekennzeichnet, daß die Mittel zur Verarbeitung des Signals des Induktionsaufnehmers mindestens einen Spannungsverstärker (54) und/oder einen Filter (55) enthalten.

**16.** Anlage nach irgendeinem der Patentansprüche 11 bis 15, gekennzeichnet durch mehrere Einheiten zum chemischen Sortieren (19), von denen jede Batterien und/oder Akkumulatoren einer bestimmten Form und Größe zugeordnet ist, die durch die Mittel zum mechanischen Sortieren (10) ausgewählt werden, und wobei jede eine Sortiervorrichtung (18) mit mindestens zwei und vorzugsweise drei Wegen steuert.

**17.** Anlage nach irgendeinem der Patentansprüche 11 bis 16, gekennzeichnet durch mindestens eine Einheit zum chemischen Sortieren (19), die mit einer Sortiervorrichtung versehen ist, die von dieser Einheit sortierte Batterien oder Akkumulatoren einer weiteren Messung einer anderen Induktionsantwort, entweder durch dieselbe Sortiereinheit mit anderer Einstellung oder durch eine andere Sortiereinheit, zuführt.

**18.** Anlage nach irgendeinem der Patentansprüche 11 bis 17, dadurch gekennzeichnet, daß
   - die Mittel zum mechanischen Sortieren (10) derart angeordnet sind, daß sie die Batterien oder Akkumulatoren in mehrere Gruppen von Batterien und/oder Akkumulatoren ähnlicher Form und Abmessungen sortieren,
   - die Mittel zum chemischen Sortieren mehrere Sortiereinheiten (19) umfassen, die entweder alle diese Gruppen empfangen oder bestimmte dieser Gruppen, die dieses chemische Sortieren erfordern, während die anderen Gruppen diesem chemischen Sortieren nicht unterworfen werden, und
   - Bahnen zur Gruppierung der Batterien und Akkumulatoren, die dem chemischen Sortieren unterworfen sind oder nicht, in Gruppen, deren chemische Beschaffenheit der Aufbereitung zur Rückgewinnung der Metalle angepaßt ist.

**19.** Vorrichtung zur Messung der ferromagnetischen Eigenschaften verbrauchter Batterien oder Akkumulatoren im Sortierverfahren nach irgendeinem der Patentansprüche 1 bis 10, wobei die Vorrichtung einen Erregerkreis (50, 51) zur Erzeugung eines magnetischen Feldes enthält, Mittel (21) zur Bewegung der Batterien oder Akkumulatoren durch dieses magnetische Feld mit einer auf ±10% konstanten Geschwindigkeit, einen Aufnehmer (53) des induzierten elektrischen Flusses, den die Batterien oder Akkumulatoren erzeugen, wenn sie durch dieses Feld hindurchgehen, und Mittel zur Verarbeitung (54, 55) des Signals des Aufnehmers zur Erzeugung einer Induktionsantwort mit zwei Komponenten, von denen die eine die ferromagnetische Masse der Batterie oder des Akkumulators angibt und die andere die Verteilung der ferromagnetischen Masse darin.

PILES & ACCUS USAGÉS
1'000 kg - 25'000 unités

229 kg - 3'000 unités

436 kg - 4'950 unités

319 kg - 15'500 unités

3 kg - 1'500 unités

13 kg - 50 unités

Fig. 1

| CLASSE 1 | CLASSE 2 | CLASSE 3 | CLASSE 4 | CLASSE 5 |
|---|---|---|---|---|
| MULTICELLS | BOUTONS | CYLINDRES Dia < 17 mm | CYLINDRES Dia > 20 mm | PRISMES |

EP 0 578 688 B1

# Fig. 2

20

Fig.3

LOT IV
Piles au
mercure

LOT III
Accus
Ni/Cd
Ni/H2

LOT II
Piles au
Zinc

LOT I
Accus
Pb/Acide

EP 0 578 688 B1

# Fig. 4

Fig. 4a        Fig. 4b        Fig. 4c

EP 0 578 688 B1

Fig. 5

Fig. 6

Fig. 7

Fig. 8

Fig. 9

Fig. 9a

EP 0 578 688 B1